# EUROPEAN PATENT APPLICATION

(11) **EP 4 415 043 A1**
(43) Date of publication of application: **14.08.2024**
(21) Application number: 22878198.5
(22) Date of filing: 16.08.2022
(51) Int. Cl.: H01L 23/522, H01L 21/768, H01L 21/822, H01L 27/00, H01L 27/04, H01L 27/146

(54) **SEMICONDUCTOR DEVICE**

(30) Priority: 08.10.2021 JP 2021166334
(71) Applicant: Sony Semiconductor Solutions Corporation, Atsugi-shi, Kanagawa 243-0014 (JP)
(72) Inventor: ARAI, Chihiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/030931
(87) International publication number: WO 2023/058327

(57) **Abstract**

To improve characteristics in a semiconductor apparatus manufactured from a wafer shared in a plurality of manufacturing processes.

A semiconductor apparatus includes an opening for a pad, a wiring layer, and a dummy pattern. In the semiconductor apparatus, the opening for a pad is formed on a front surface of a substrate. In addition, in the semiconductor apparatus, a predetermined electrode pad is provided in the opening for a pad. In the semiconductor apparatus, a front surface-side wiring layer is formed in the substrate. In the semiconductor apparatus, a dummy pattern is formed around a dummy non-forming region penetrating up to the front surface-side wiring layer from a rear surface relative to the front surface.

## Description

### [Technical Field]

The present technique relates to a semiconductor apparatus. More specifically, the present technique relates to a semiconductor apparatus in which a TSV (Through Silicon Via) and an electrode pad are provided.

### [Background Art]

In a semiconductor apparatus such as a solid-state imaging apparatus, a TSV has been used from the past in some cases for taking out terminals. For example, a semiconductor apparatus in which a light receiving surface of a substrate is used as a front surface and a solder ball is formed by rewiring a rear surface side relative to the front surface with use of a TSV has been proposed (see, for example, PTL 1).

### [Citation List]

### [Patent Literature]

[PTL 1]
Japanese Patent Laid-open No. 2011-009645

### [Summary]

### [Technical Problem]

In the above-described background art, the TSV is used to rewire the rear surface side and a solder ball is formed to realize downsizing as compared with a case of using wire bonding. However, in the above-described semiconductor apparatus, when a wafer is shared in a plurality of manufacturing processes, there is a risk that a parasitic capacitance between the rear surface of a substrate and a wiring layer becomes large. For example, in the case where a wafer is shared in the manufacturing process of each of a WLCSP (Wafer Level Chip Scale Package) and a ceramic package, the parasitic capacitance becomes larger than the case where a wafer is not shared in the ceramic package. Due to the increase in parasitic capacitance, there is a problem that characteristics such as operation speeds and high-frequency characteristics are reduced.

The present technique has been developed in view of such a situation, and the object thereof is to improve characteristics in a semiconductor apparatus manufactured from a wafer shared in a plurality of manufacturing processes.

### [Solution to Problem]

The present technique has been developed to solve the above-described problem, and a first aspect thereof is a semiconductor apparatus including an opening for a pad that is formed on a front surface of a substrate and provided with a predetermined electrode pad, a wiring layer that is formed in the substrate, and a dummy pattern that is formed around a dummy non-forming region penetrating the substrate up to the wiring layer from a rear surface relative to the front surface. Accordingly, the parasitic capacitance is advantageously reduced when a wafer is shared in a plurality of manufacturing processes.

In addition, in the first aspect, the substrate may be a substrate obtained by laminating a pixel sensor substrate and a logic substrate, the opening for a pad may be formed on the front surface of the pixel sensor substrate, and the wiring layer and the dummy pattern may be formed in the logic substrate. Accordingly, the parasitic capacitance is advantageously reduced in the laminated substrate.

In addition, in the first aspect, the dummy non-forming region may be opened, and a TSV (Through Silicon Via) may be formed. Accordingly, a terminal is advantageously taken out from the rear surface side.

In addition, in the first aspect, an area of the dummy non-forming region on a plane parallel to the substrate may be smaller as it becomes closer to the wiring layer. Accordingly, the dummy occupancy advantageously becomes higher in upper layers.

In addition, in the first aspect, a position of the opening for a pad on a plane parallel to the substrate and a position of the dummy non-forming region on the plane may be different from each other. Accordingly, cracks and the like are advantageously suppressed.

In addition, in the first aspect, a shape of the boundary region between the wiring layer and the dummy non-forming region may be a circular shape. Accordingly, the upper end of the TSV advantageously has a circular shape.

In addition, in the first aspect, the shape of the boundary region between the wiring layer and the dummy non-forming region may be a ring shape. Accordingly, the upper end of the TSV advantageously has a ring shape.

In addition, in the first aspect, the dummy non-forming region may be in contact with the wiring layer in a plurality of boundary regions. Accordingly, the TSV advantageously has a plurality of upper ends.

In addition, in the first aspect, a part of the dummy pattern and the wiring layer may be short-circuited. Accordingly, the contact resistance of the TSV is advantageously reduced.

In addition, in the first aspect, a density of the dummy pattern may be higher as it becomes closer to the wiring layer. Accordingly, a rule related to a distance from the TSV to the surrounding device is advantageously relaxed.

In addition, in the first aspect, the dummy pattern may include dummy wiring wired in a mesh shape. Accordingly, the density of conductors advantageously becomes higher than that in the case of an island-like shape.

In addition, in the first aspect, the dummy wiring may include a first dummy wiring and a second dummy wiring wired between the first dummy wiring and the wiring layer, and a position of the second dummy wiring on a plane parallel to the substrate may be different from that of the first dummy wiring. Accordingly, the dummy wirings are advantageously alternated between the upper layer and the lower layer.

In addition, in the first aspect, the dummy pattern may include a plurality of islands arranged in a two-dimensional lattice shape. Accordingly, the parasitic capacitance is advantageously reduced.

In addition, in the first aspect, the plurality of islands may include a first island and a second island wired between the first island and the wiring layer, and a position of the second island on a plane parallel to the substrate may be different from that of the first island. Accordingly, the density of conductors becomes lower than that in the case of the mesh-like shape.

In addition, in the first aspect, a side surface of the dummy non-forming region may be formed in a tapered shape. Accordingly, the area of the upper end of the TSV advantageously becomes the smallest.

In addition, in the first aspect, a side surface of the dummy non-forming region may be formed stepwise. Accordingly, the area of the upper end of the TSV advantageously becomes the smallest.

### [Brief Description of Drawings]

[FIG. 1]

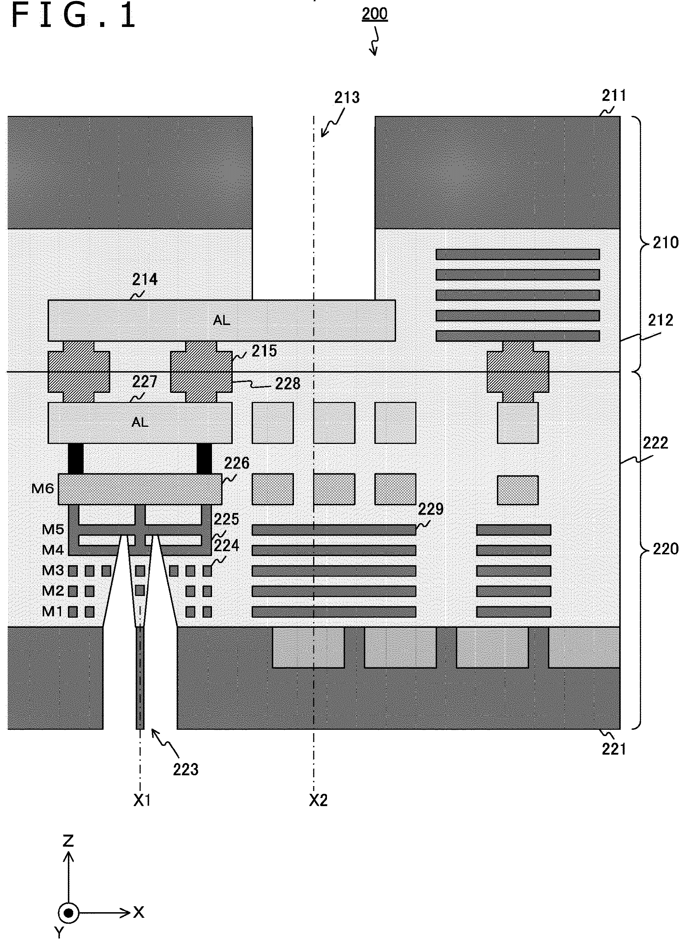

   FIG. 1 is a cross-sectional view for depicting a configuration example of a laminated wafer used when manufacturing a WLCSP in an embodiment of the present technique.
[FIG. 2]

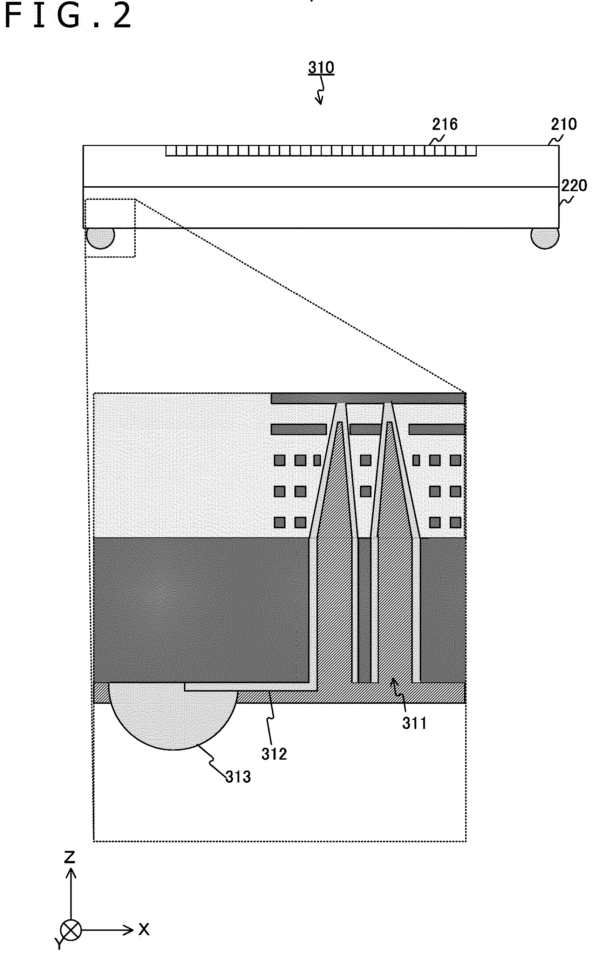

   FIG. 2 is a cross-sectional view for depicting a configuration example of the WLCSP in the embodiment of the present technique.
[FIG. 3]

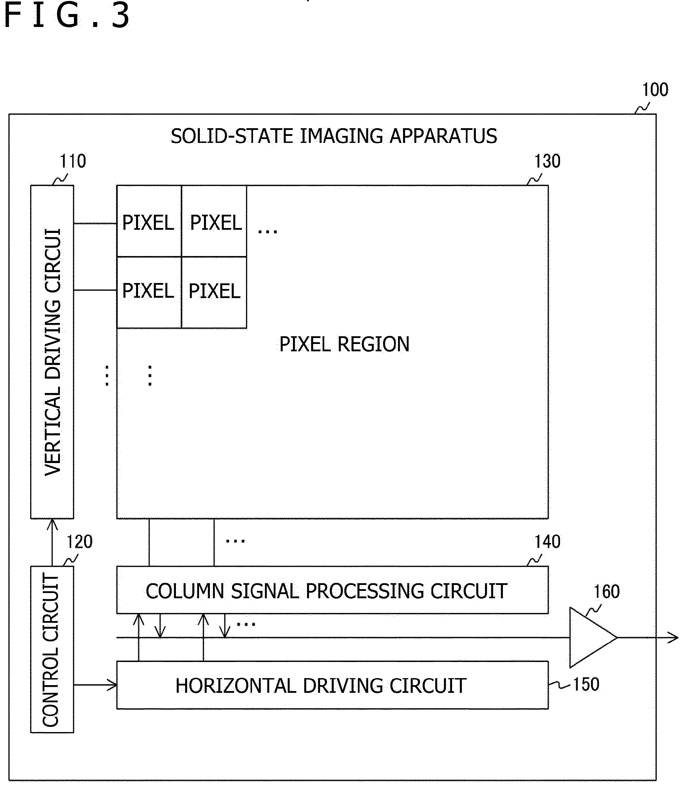

   FIG. 3 is a block diagram for depicting a configuration example of a solid-state imaging apparatus in the embodiment of the present technique.
[FIG. 4]

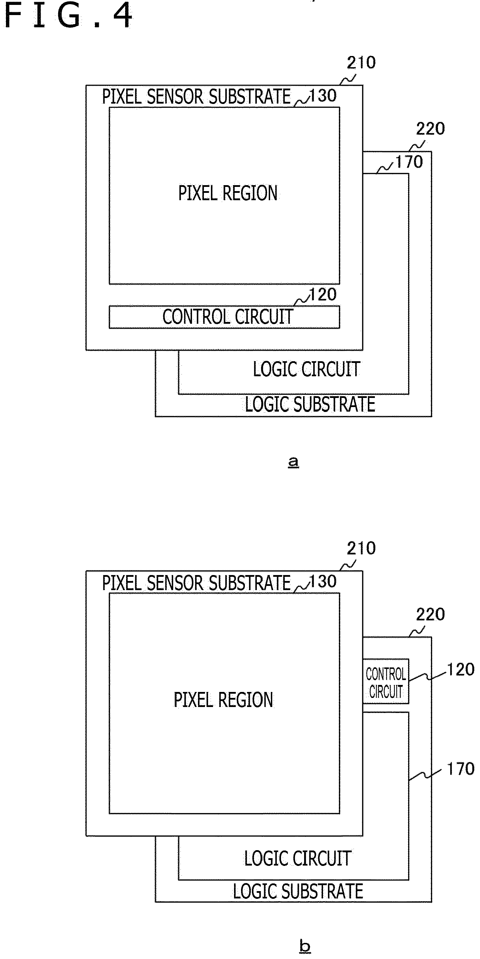

   FIG. 4 depicts diagrams each depicting an example of a laminated structure of the solid-state imaging apparatus in the embodiment of the present technique.
[FIG. 5]

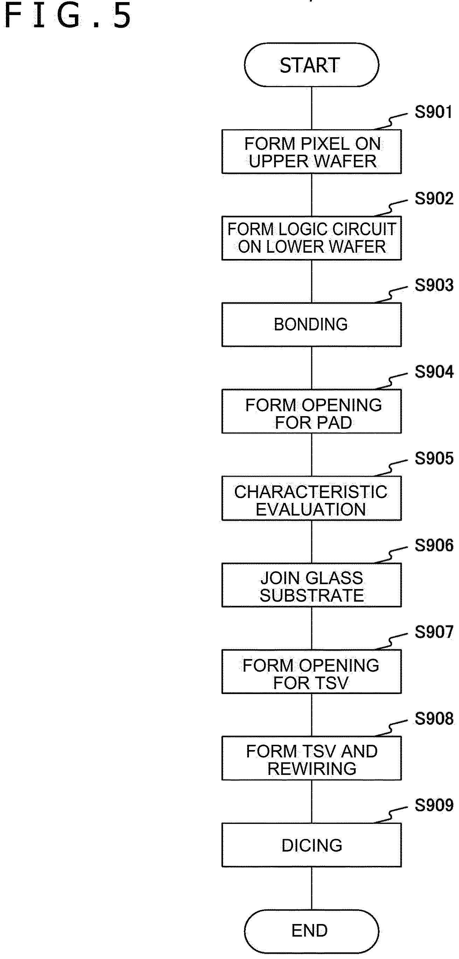

   FIG. 5 is a flowchart for depicting an example of a manufacturing process of the WLCSP in the embodiment of the present technique.
[FIG. 6]

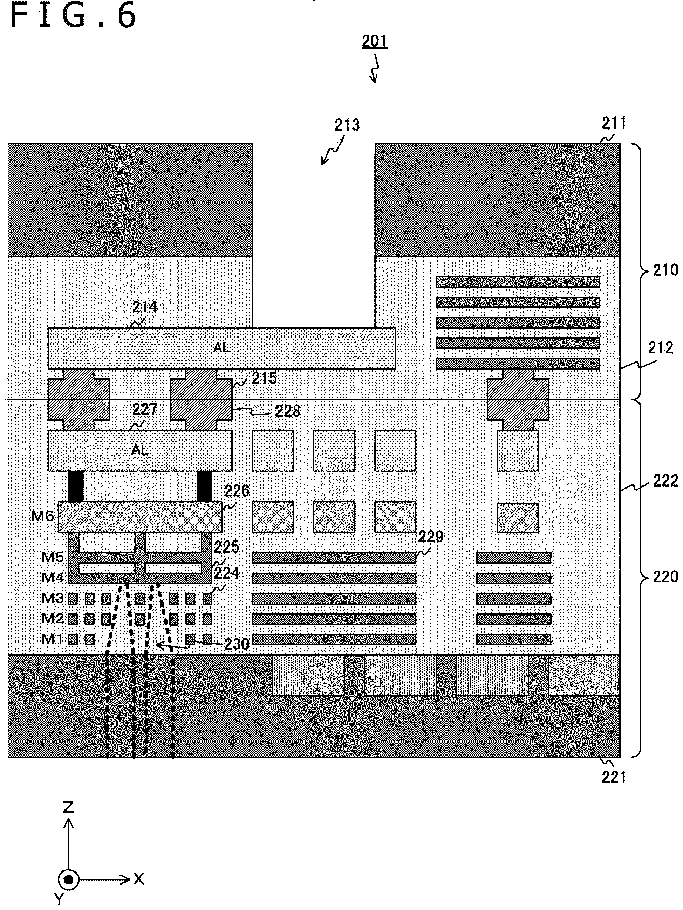

   FIG. 6 is a cross-sectional view for depicting a configuration example of the laminated wafer used when manufacturing a ceramic package in the embodiment of the present technique.
[FIG. 7]

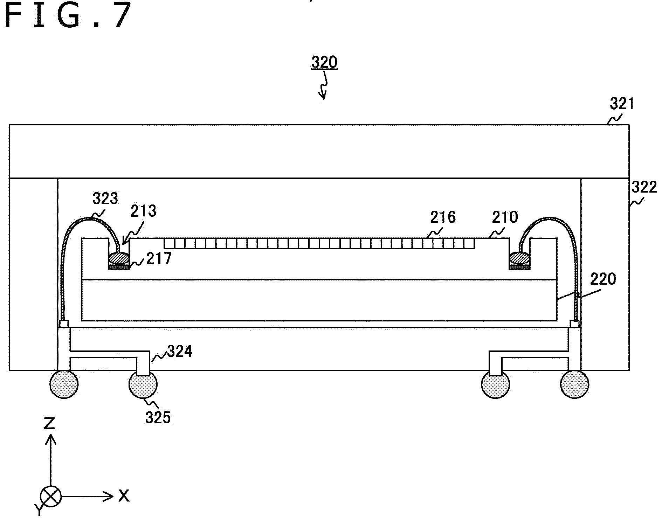

   FIG. 7 is a cross-sectional view for depicting a configuration example of the ceramic package in the embodiment of the present technique.
[FIG. 8]

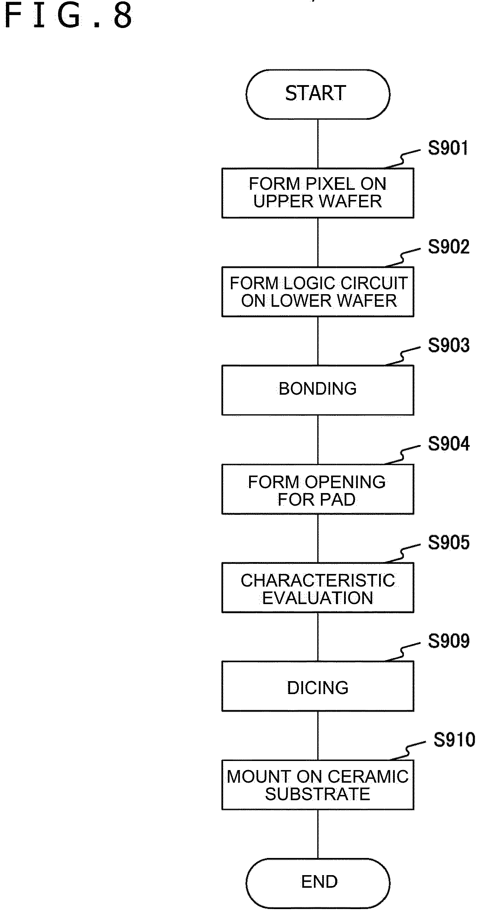

   FIG. 8 is a flowchart for depicting an example of a manufacturing process of the ceramic package in a first embodiment of the present technique.
[FIG. 9]

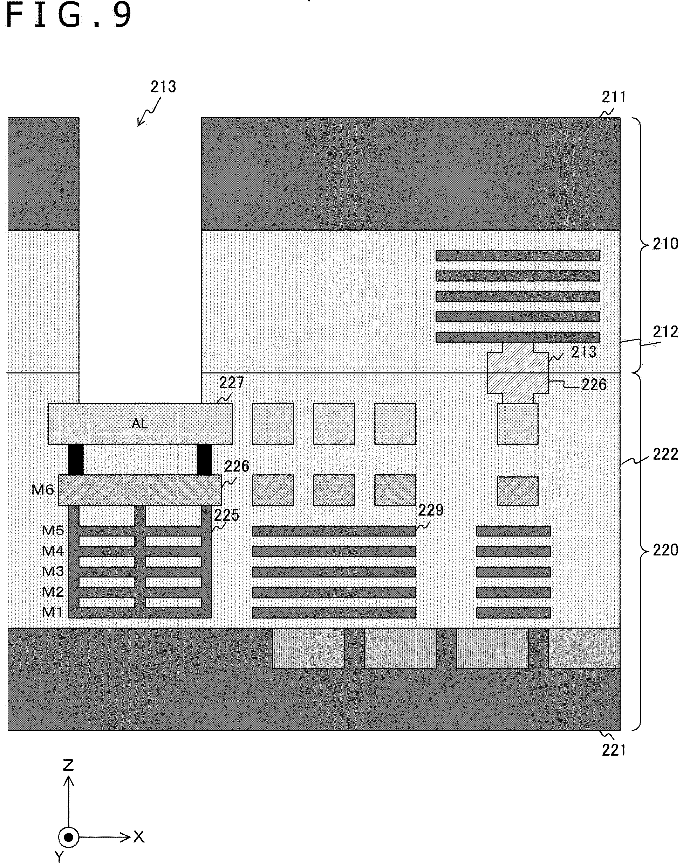

   FIG. 9 is a cross-sectional view for depicting a configuration example of a laminated wafer in a first comparative example.
[FIG. 10]

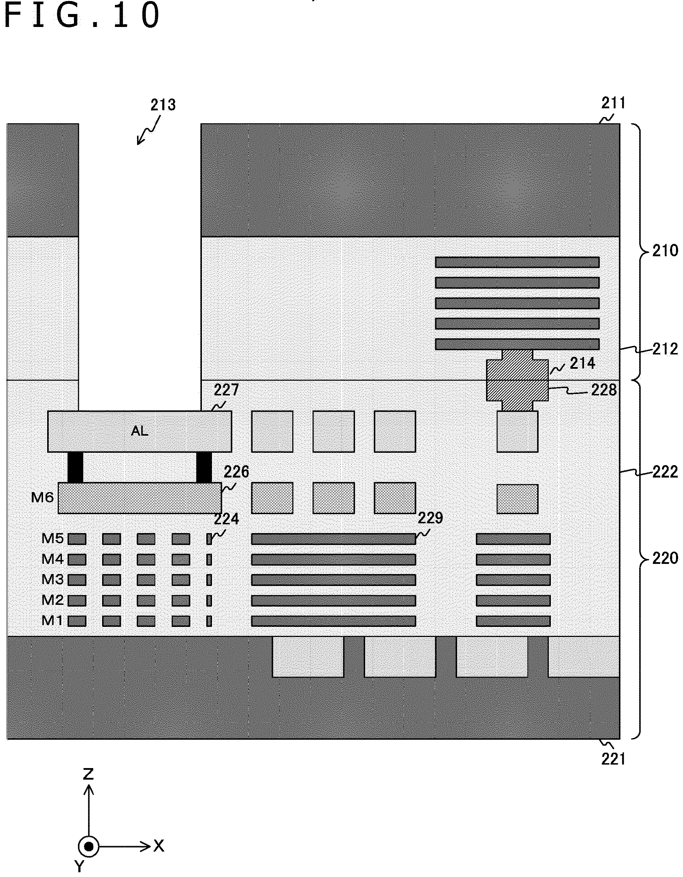

   FIG. 10 is a cross-sectional view for depicting a configuration example of a laminated wafer in a second comparative example.
[FIG. 11]

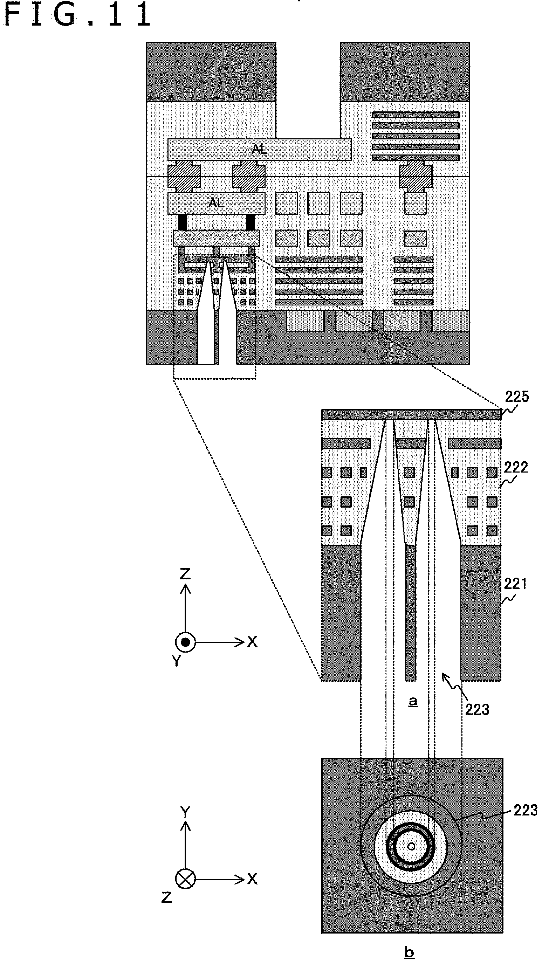

   FIG. 11 depict an example of a cross-sectional view and a plan view of an opening for a TSV in the embodiment of the present technique.
[FIG. 12]

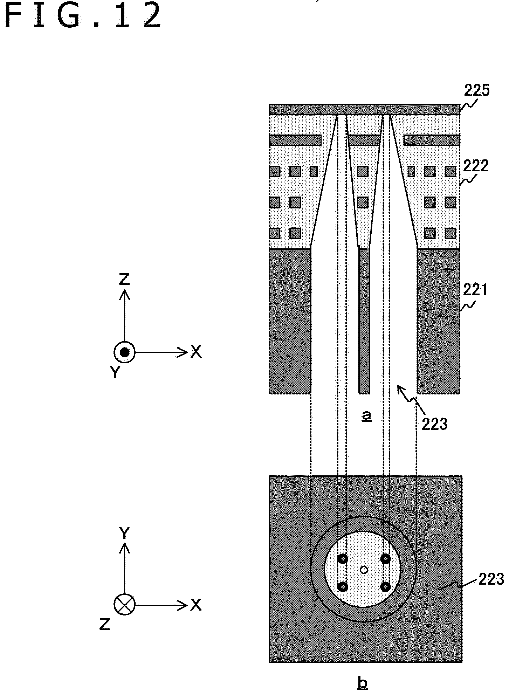

   FIG. 12 depicts diagrams for depicting another example of a cross-sectional view and a plan view of the opening for a TSV in the embodiment of the present technique.
[FIG. 13]

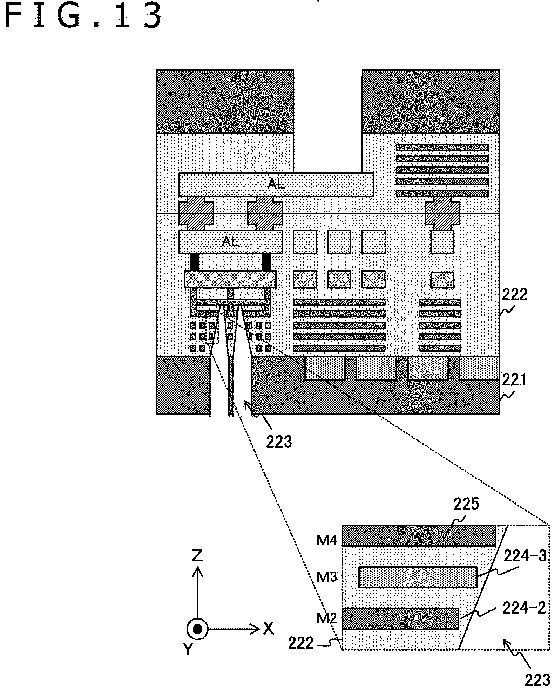

   FIG. 13 is a diagram for depicting an example of a cross-sectional view of a dummy pattern in the embodiment of the present technique.
[FIG. 14]

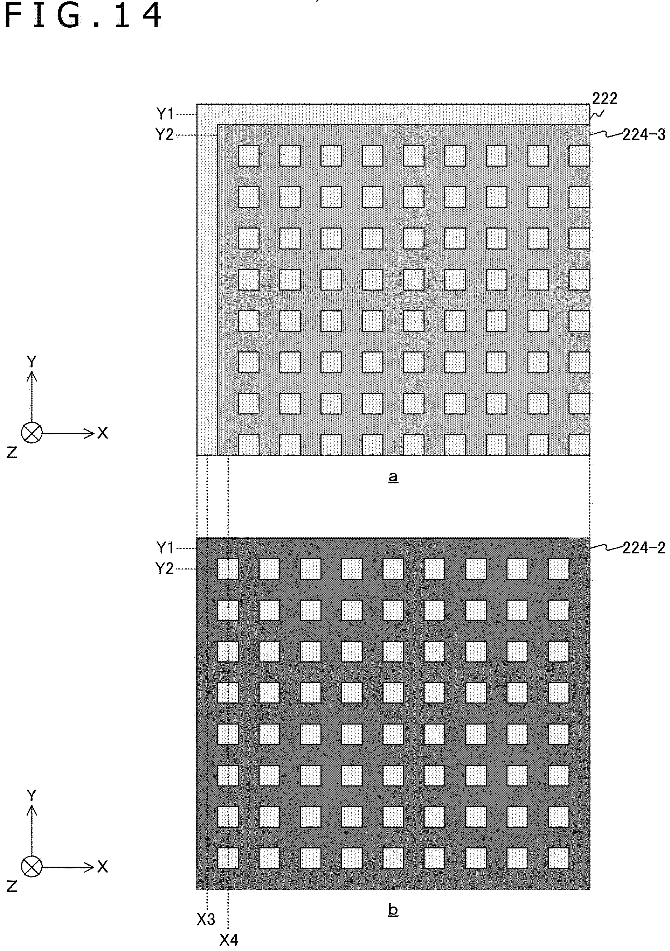

   FIG. 14 depicts diagrams each depicting an example of a plan view of the dummy pattern in the embodiment of the present technique.
[FIG. 15]

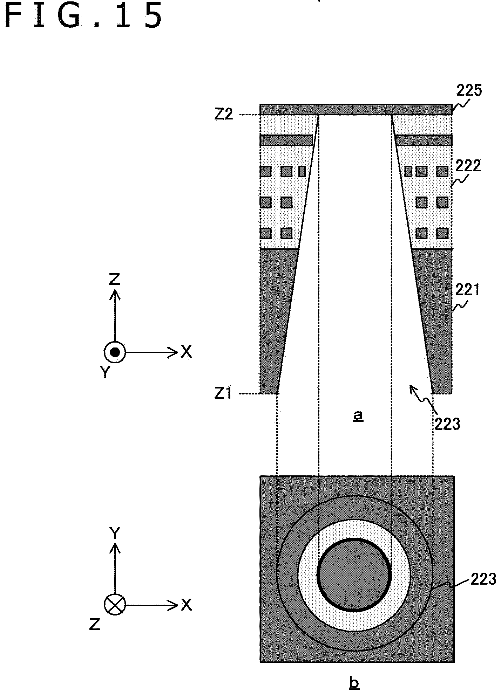

   FIG. 15 depicts diagrams for depicting an example of a cross-sectional view and a plan view of an opening for a TSV in a first modified example of the embodiment of the present technique.
[FIG. 16]

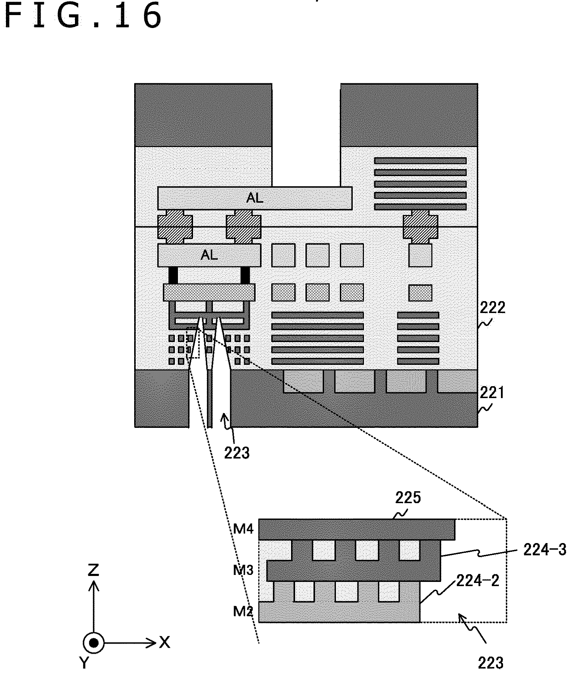

   FIG. 16 is a diagram for depicting an example of a cross-sectional view of a dummy pattern in a second modified example of the embodiment of the present technique.
[FIG. 17]

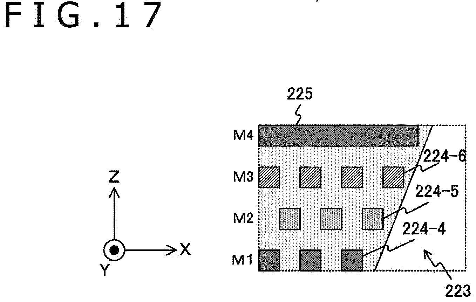

   FIG. 17 is a diagram for depicting an example of a cross-sectional view of a dummy pattern in a third modified example of the embodiment of the present technique.
[FIG. 18]

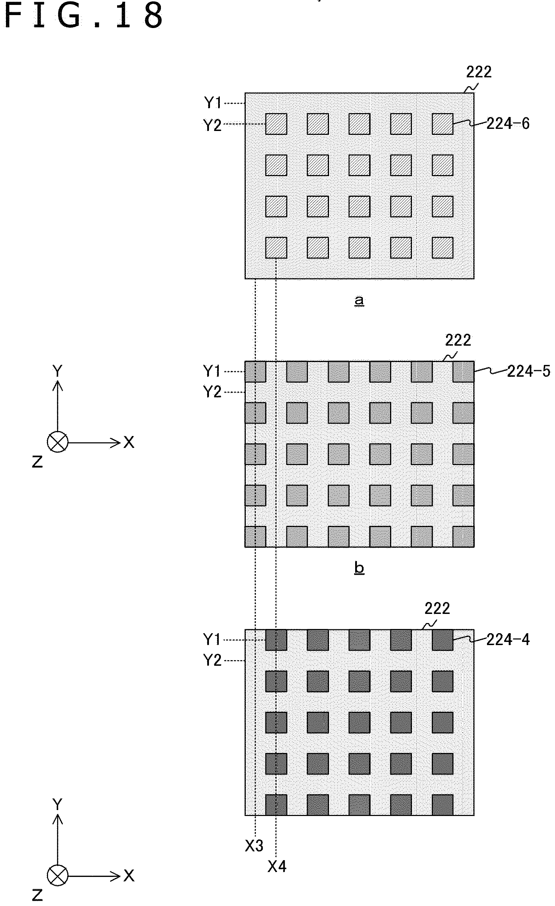

   FIG. 18 depicts diagrams each depicting an example of a plan view of the dummy pattern in the third modified example of the embodiment of the present technique.
[FIG. 19]

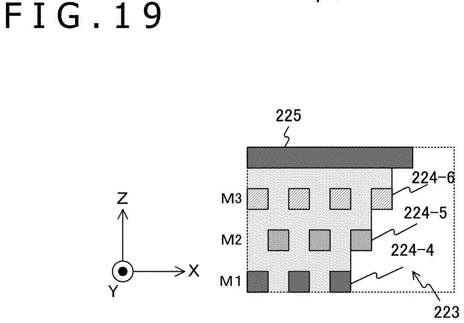

   FIG. 19 is a diagram for depicting another example of a cross-sectional view of an opening for a TSV in the third modified example of the embodiment of the present technique.
[FIG. 20]

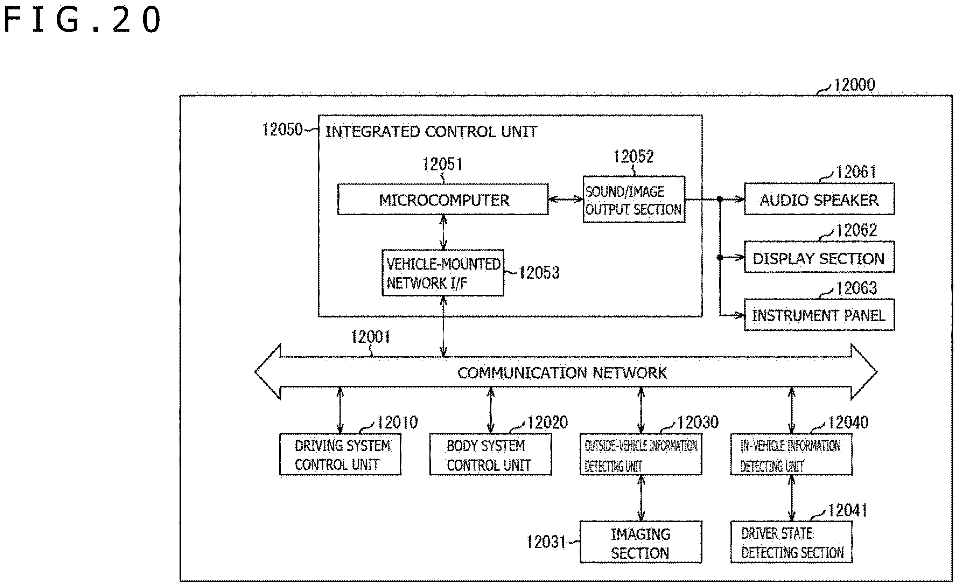

   FIG. 20 is a block diagram depicting an example of schematic configuration of a vehicle control system.
[FIG. 21]

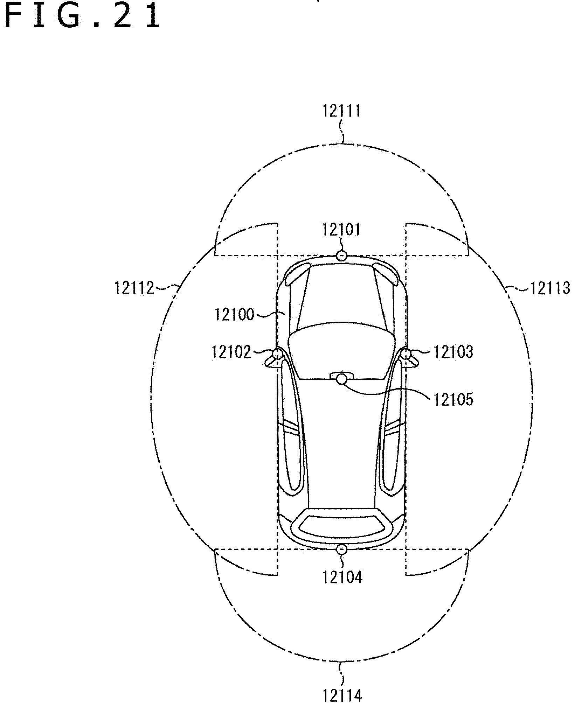

   FIG. 21 is a diagram of assistance in explaining an example of installation positions of an imaging section.

### [Description of Embodiments]

Hereinafter, a mode (hereinafter, referred to as an embodiment) for carrying out the present technique will be described. The explanation will be given in the following order.
1. Embodiment (example of forming a dummy pattern around a dummy non-forming region)
2. Example of application to a mobile body

### <1. First Embodiment>

### [Configuration example of laminated wafer]

FIG. 1 is a cross-sectional view for depicting a configuration example of a laminated wafer 200 used when manufacturing a WLCSP in an embodiment of the present technique. This laminated wafer 200 is formed by laminating two wafers, and one of the two wafers includes a predetermined number of pixel sensor substrates 210. The other wafer includes a predetermined number of logic substrates 220. Hereinafter, the axis parallel to the lamination direction of the wafer will be assumed to be a Z axis. In addition, a predetermined axis perpendicular to the Z axis will be assumed to be an X axis, and the axis perpendicular to the Z axis and the X axis will be assumed to be a Y axis. The drawing is a cross-sectional view viewed from the Y axis direction.

A plurality of pixels (not depicted) are provided on a light receiving surface of the pixel sensor substrate 210. With the light receiving surface as a "front surface," a "rear surface" of the pixel sensor substrate 210 relative to the front surface is connected to the logic substrate 220. In addition, in the logic substrate 220, the connection surface with the pixel sensor substrate 210 will be assumed to be the front surface. In addition, the direction to the front surface will be assumed to be an "upper" direction, and the direction to the rear surface will be assumed to be a "lower" direction.

In addition, the pixel sensor substrate 210 includes an Si (semiconductor) substrate 211 on the front surface side and an interlayer film 212 on the rear surface side. A wiring 214 for external connection and a connection part 215 are formed in the interlayer film 212. The wiring 214 for external connection is a wiring for electrically connecting the pixel sensor substrate 210 and external parts (such as the logic substrate 220, and a test apparatus) to each other, and an aluminum wiring or the like is used. The pixel sensor substrate 210 is electrically connected to the logic substrate 220 via the wiring 214 for external connection and the connection part 215. As a connection method of these substrates, for example, Cu-Cu connection is used.

In addition, on the front surface (that is, the light receiving surface) of the pixel sensor substrate 210, an opening 213 for a pad that penetrates up to the wiring 214 for external connection is formed. An electrode pad to be described later is provided in the opening 213 for a pad, and the pixel sensor substrate 210 is electrically connected to the outside via the electrode pad. In the manufacturing process of the WLCSP, it is connected to an external test apparatus or the like to evaluate the characteristics of the pixel sensor substrate 210.

A circuit for processing pixel signals from pixels is formed in the logic substrate 220. The logic substrate 220 includes an interlayer film 222 on the front surface side and an Si (semiconductor) substrate 221 on the rear surface side. A dummy pattern 224, a local wiring 225, a global wiring 226, a wiring 227 for external connection, a connection part 228, and a local wiring 229 are formed in the interlayer film 222.

The wiring 227 for external connection is a wiring for electrically connecting the logic substrate 220 and the pixel sensor substrate 210 to each other, and an aluminum wiring or the like is used. The logic substrate 220 is electrically connected to the pixel sensor substrate 210 via the wiring 227 for external connection and the connection part 228.

The global wiring 226 is a wiring for connecting a plurality of circuit blocks to each other. The local wiring 225 is a wiring in the circuit blocks. The local wiring 225 is wired to the lower layer of the global wiring 226. For example, the local wiring 225 forms a front surface-side wiring layer M5 and a front surface-side wiring layer M4 in the lower layer thereof. It should be noted that although the local wiring 225 has two layers, if it has one or more layers, it is not limited to two layers.

The dummy pattern 224 is a pattern of conductors that do not configure a circuit. The dummy pattern 224 forms, for example, a rear surface-side wiring layer M3 in the lower layer of the front surface-side wiring layer M4, a rear surface-side wiring layer M2 in the lower layer thereof, and a rear surface-side wiring layer M1 in the lower layer thereof. It should be noted that the dummy pattern 224 has three layers, but if it has one or more layers, it is not limited to three layers.

In addition, on the rear surface of the logic substrate 220, an opening 223 for a TSV that penetrates up to the front surface-side wiring layer M5 is formed. The opening 223 for a TSV is provided for forming a TSV and a rewiring, which will be described later.

The area of the opening 223 for a TSV on the X-Y plane parallel to the logic substrate 220 is preferably smaller as it becomes closer to the front surface-side wiring layer M5. For example, the area of the upper end of the opening 223 for a TSV is preferably 10 percent (%) or more of the area of the lower end. In addition, the side surface of the opening 223 for a TSV is formed in a tapered shape.

In addition, the position of the opening 213 for a pad on the X-Y plane is preferably different from the position of the opening 223 for a TSV. For example, a center coordinate of the opening 223 for a TSV is X1, and a center coordinate of the opening 213 for a pad is X2.

In addition, a density of the dummy pattern 224 is higher as it becomes closer to the front surface-side wiring layer M5 (in other words, closer to upper parts).

Here, in the logic substrate 220 that receives the TSV, it is better to form the wiring layers (M4 and M5) of the local wiring on the upper layer side in order to reduce an increase in capacity when a ceramic package is mounted to be described later. However, in the case where the dummy wiring cannot be laid out in the layer lower than the wiring layer in the upper layer, there is a risk of hindering smoothing in the middle of processing. In addition, as the TSV becomes deeper, the stress around the TSV increases, and a KOZ (Keep Out Zone) rule becomes stricter. A KOZ rule is a rule in which the distance from the TSV to the surrounding device is equal to or larger than the lower limit value, and the lower limit value becomes smaller in the upper parts in the drawing.

Therefore, as described above, the density of the dummy pattern 224 is made higher in the upper layers, and the side surface of the opening 223 for a TSV is tapered to minimize the size of the bottom region of the TSV in contact with the local wiring 225.

In addition, in the wiring process of the wafer on the lower side, a certain level or more of the wiring density of the dummy pattern 224 must be secured for smoothing. As described above, by setting the area of the upper end of the opening 223 for a TSV to be 10 percent (%) or more of the lower end, the dummy occupancy can be secured to be higher in the upper parts where the smoothing becomes severe. Since a TSV diameter of the receiving part for the TSV can be formed small, the stress can be reduced and the KOZ rule can be relaxed.

In addition, if the position of the opening 213 for a pad overlaps with the position of the opening 223 for a TSV, a thickness of the interlayer films 212 and 222 from the lower end of the opening 213 for a pad to the upper end of the opening 223 for a TSV becomes thinner than the other portions. Accordingly, there is a risk that the mechanical strength becomes insufficient. As exemplified in the drawing, by shifting the position of the opening 213 for a pad and the position of the opening 223 for a TSV, it is possible to improve the resistance to mechanical stress from a DAM material or the like around a chip when the WLCSP is mounted. Accordingly, cracks or the like caused by the stress can be suppressed.

In addition, the local wiring 229 is formed at a place other than the upper part of the opening 223 for a TSV. The local wiring 229 forms a wiring layer having five layers, unlike the local wiring 225 having two layers at the upper part of the opening 223 for a TSV.

Although the dummy pattern 224 is not electrically required, the wiring layer can be aligned to have five layers at the upper part of the opening 223 for a TSV and other portions by forming the dummy pattern 224. Therefore, when the rear surface of the logic substrate 220 is smoothed, shaving unevenness can be suppressed.

In summary, the opening 213 for a pad is formed on the front surface of the laminated wafer 200, and the electrode pad to be connected to the test apparatus is provided in the opening 213 for a pad. In addition, the front surface-side wiring layer M5 and the like are formed in the laminated wafer 200, and the opening 223 for a TSV that penetrates up to the front surface-side wiring layer M5 from the rear surface is formed. The dummy pattern 224 is formed around the opening 223 for a TSV.

### [Configuration example of WLCSP]

FIG. 2 is a cross-sectional view for depicting a configuration example of a WLCSP 310 in the embodiment of the present technique. The WLCSP 310 is manufactured by forming a TSV, a rewiring, and the like in the above-described laminated wafer 200 and dicing.

A plurality of pixels such as pixels 216 are formed in the pixel sensor substrate 210. In addition, a TSV 311 and a rewiring 312 are formed in the opening 223 for a TSV on the rear surface of the logic substrate 220. In addition, an external terminal 313 such as a solder ball is provided on the rear surface, and the external terminal 313 is connected to a circuit in the logic substrate 220 via the rewiring 312.

### [Configuration example of solid-state imaging apparatus]

FIG. 3 is a block diagram for depicting a configuration example of a solid-state imaging apparatus 100 in the embodiment of the present technique. The above-described WLCSP 310 functions as the solid-state imaging apparatus 100 in the drawing. It should be noted that the solid-state imaging apparatus 100 is an example of a semiconductor apparatus described in Claims.

The solid-state imaging apparatus 100 is an apparatus for imaging image data, and includes a vertical driving circuit 110, a control circuit 120, a pixel region 130, a column signal processing circuit 140, a horizontal driving circuit 150, and an output circuit 160. A plurality of pixels are arranged in a two-dimensional lattice shape in the pixel region 130.

The vertical driving circuit 110 includes, for example, a shift register, drives the pixels in a row unit, and outputs a pixel signal. The control circuit 120 controls the operation timing of the vertical driving circuit 110, the column signal processing circuit 140, and the horizontal driving circuit 150 in synchronization with a vertical synchronization signal or the like from the outside.

The column signal processing circuit 140 performs signal processing such as AD (Analog to Digital) conversion for pixel signals from each column of the pixel region 130. The column signal processing circuit 140 is provided with an ADC (Analog to Digital Converter) for, for example, each column, and performs AD conversion by the column ADC method. In addition, the column signal processing circuit 140 further performs CDS (Correlated Double Sampling) processing for removing a fixed pattern noise. The column signal processing circuit 140 supplies the processed pixel signal to the output circuit 160 according to the control of the horizontal driving circuit 150.

The horizontal driving circuit 150 supplies a horizontal scanning pulse signal to the column signal processing circuit 140 according to the control of the control circuit 120, and sequentially outputs the processed pixel signal.

The output circuit 160 outputs image data in which the pixel signals from the column signal processing circuit 140 are arranged to the outside.

FIG. 4 depicts diagrams each depicting an example of a laminated structure of the solid-state imaging apparatus in the embodiment of the present technique. For example, as exemplified in a in the drawings, the pixel region 130 and the control circuit 120 are arranged in the pixel sensor substrate 210, and the remaining circuits (the column signal processing circuit 140 and the like) are arranged in the logic substrate 220 as a logic circuit 170.

Alternatively, as exemplified in b in the drawings, the pixel region 130 is arranged in the pixel sensor substrate 210, and the remaining control circuit 120 and logic circuit 170 are arranged in the logic substrate 220.

### [Manufacturing method of WLCSP]

FIG. 5 is a flowchart for depicting an example of a manufacturing process of the WLCSP 310 in the embodiment of the present technique. In a semiconductor package manufacturing system, first, pixels and the like are formed on the upper wafer (Step S901), the logic circuit 170 and the like are formed on the lower wafer (Step S902), and the upper wafer and the lower wafer are bonded together (Step S903). Then, the manufacturing system forms the opening 213 for a pad (Step S904). It should be noted that Step S901 and Step S902 can be performed in parallel.

Then, the manufacturing system provides the electrode pad in the opening 213 for a pad and performs characteristic evaluation (Step S905). Next, the manufacturing system joins a glass substrate to the front surface of the laminated substrate via a DAM material (Step S906), and forms the opening 223 for a TSV (Step S907). The above-described cross-sectional view of the laminated wafer 200 depicts a cross-sectional view at the time of Step S907. In addition, the manufacturing system forms the TSV and the rewiring in the opening 223 for a TSV (Step S908). Next, the manufacturing system dices the laminated wafer 200 to manufacture a predetermined number of WLCSPs 310 (Step S909). After Step S909, the manufacturing system terminates the manufacturing process of the WLCSP 310.

In the manufacturing process of the drawing, although the laminated wafer 200 having the structure exemplified in FIG. 1 is used, a ceramic package can be manufactured using a laminated wafer having the same structure except that the opening 223 for a TSV is not opened.

FIG. 6 is a cross-sectional view for depicting a configuration example of a laminated wafer 201 used when manufacturing a ceramic package in the embodiment of the present technique. The laminated wafer 201 has the same structure as the laminated wafer 200 except that a dummy non-forming region 230 is arranged in place of the opening 223 for a TSV. In other words, the laminated wafer 201 has the same structure as the laminated wafer 200 before the opening 223 for a TSV is formed. The region enclosed by the dotted line in the drawing indicates the dummy non-forming region 230.

The dummy non-forming region 230 is a region in the Si substrate 221 and the interlayer film 222 in which the dummy pattern 224 is not formed. The dummy pattern 224 is formed therearound while avoiding the dummy non-forming region 230.

### [Configuration example of ceramic package]

FIG. 7 is a cross-sectional view for depicting a configuration example of a ceramic package 320 in the embodiment of the present technique. The ceramic package 320 is manufactured by dicing the above-described laminated wafer 201 and mounting it on a ceramic substrate.

The ceramic package 320 includes glass 321 and a ceramic substrate 322, and also includes a pixel sensor substrate 210 and a logic substrate 220 that are laminated. The glass 321 is mounted on the upper part of the pixel sensor substrate 210.

An external connection terminal 325 such as a solder ball is provided on the lower surface of the ceramic substrate 322. The external connection terminal 325 is connected to one end of a rewiring 324 wired in the ceramic substrate 322. The other end of the rewiring 324 is connected to a wire 323. In addition, an electrode pad 217 is provided in the opening 213 for a pad of the pixel sensor substrate 210. The electrode pad 217 is connected to the rewiring 324 via the wire 323.

As exemplified in the drawing, since the ceramic package 320 is mounted by wire bonding to the electrode pad on the pixel sensor substrate 210 side, it is not necessary to form a TSV on the rear surface of the logic substrate 220. Therefore, as described above, the rear surface of the laminated wafer 201 is not opened.

### [Manufacturing method of ceramic package]

FIG. 8 is a flowchart for depicting an example of a manufacturing process of the ceramic package 320 in a first embodiment of the present technique. In the manufacturing system, pixels and the like are formed on the upper wafer (Step S901), the logic circuit 170 and the like are formed on the lower wafer (Step S902), and the upper wafer and the lower wafer are bonded together (Step S903). Then, the manufacturing system forms the opening 213 for a pad (Step S904). The above-described cross-sectional view of the laminated wafer 201 depicts a cross-sectional view at the time of Step S904.

Then, the manufacturing system provides the electrode pad in the opening 213 for a pad and performs characteristic evaluation (Step S905). Next, the manufacturing system dices the laminated wafer 200 (Step S909), and mounts it on the ceramic substrate 322 to manufacture a predetermined number of ceramic packages 320 (Step S910). After Step S910, the manufacturing system terminates the manufacturing process of the ceramic package 320.

In addition, in the above-described manufacturing process of the WLCSP 310, the structure of the laminated wafer 200 in Step S904 before the opening 223 for a TSV is formed is the same as that of the laminated wafer 201 in Step S904 in the manufacturing process of the ceramic package 320. By forming the dummy pattern 224 while avoiding the dummy non-forming region 230, it is not necessary to penetrate the layer of the dummy pattern 224 when forming the TSV in the manufacturing process of the WLCSP 310, and the TSV can be easily formed.

As exemplified in FIG. 5 and FIG. 8, in the manufacturing process of the WLCSP 310 and the manufacturing process of the ceramic package 320, the processes up to Step S904 are common. Therefore, the laminated wafers can be shared in these manufacturing processes.

For example, in Step S901 to Step S904, two sets of laminated wafers having the same structure are manufactured. Step S905 and subsequent processes in FIG. 5 are executed for one set of them to manufacture the WLCSP 310. On the other hand, Step S907 and subsequent processes in FIG. 8 are executed for the remaining one set to manufacture the ceramic package 320. This common use of the laminated wafers can reduce costs and improve production liquidity.

Here, a laminated wafer having a configuration in which the dummy pattern 224 is not provided on the lower side of the local wiring 225 is assumed as a first comparative example.

FIG. 9 is a cross-sectional view for depicting a configuration example of a laminated wafer in the first comparative example. In this first comparative example, the dummy pattern 224 is not provided on the lower side of a local wiring 225, and five layers are formed by the local wiring 225. In addition, an opening 213 for a pad penetrates up to a wiring 227 for external connection of a logic substrate 220.

In the case where the laminated wafer of the drawing is shared between the manufacturing process of the WLCSP 310 and the manufacturing process of the ceramic package 320, more wiring layers are short-circuited to the wiring 227 for external connection than in the first embodiment in which the dummy pattern 224 is provided. Accordingly, in the ceramic package 320, the parasitic capacitance generated between the wiring layer and the rear surface of an Si substrate 221 becomes large. This increase in parasitic capacitance may reduce characteristics such as operation speeds and high-frequency characteristics.

In addition, a laminated wafer having a configuration in which only a dummy pattern 224 is formed on the lower side of a global wiring 226 is assumed as a second comparative example.

FIG. 10 is a cross-sectional view for depicting a configuration example of a laminated wafer in the second comparative example. In this second comparison example, the local wiring 225 is not provided on the lower side of the global wiring 226, and five layers are formed by the dummy pattern 224. In addition, an opening 213 for a pad penetrates up to a wiring 227 for external connection of a logic substrate 220.

In the laminated wafer of the drawing, since the local wiring 225 is not provided on the lower side of the global wiring 226, the parasitic capacitance between the global wiring and the rear surface can be reduced. However, since a TSV cannot be formed on the rear surface side, it can only be used in the ceramic package 320, and the laminated wafer cannot be shared with the manufacturing process of the WLCSP 310.

On the other hand, in the laminated wafers 200 and 201 exemplified in FIG. 1 and FIG. 6, since the dummy pattern 224 is provided on the lower side of the local wiring 225, the parasitic capacitance can be reduced more than in the first comparative example. Accordingly, characteristics such as operation speeds can be improved.

In addition, since the laminated wafer can be shared between the manufacturing process of the WLCSP 310 and the manufacturing process of the ceramic package 320, the cost can be reduced and the production liquidity can be improved more than in the second comparison example.

### [Configuration example of opening for TSV]

FIG. 11 depict an example of a cross-sectional view and a plan view of the opening 223 for a TSV in the embodiment of the present technique. In the drawings, a is an example of a cross-sectional view of the opening 223 for a TSV, and b in the drawings is an example of a plan view of the opening 223 for a TSV when viewed from the lower side of the logic substrate 220.

The region enclosed by the thick line in b in the drawings depicts the boundary region between the opening 223 for a TSV and the local wiring 225. The shape of the boundary region is, for example, a ring shape. The height of the center of the ring from the local wiring 225 is less than the boundary between the Si substrate 221 and the interlayer film 222, but the center of the ring may reach the boundary.

It should be noted that as exemplified in b in FIG. 12, the opening 223 for a TSV may be in contact with the local wiring 225 in a plurality of boundary regions. The shape of each boundary region is, for example, a circular shape.

### [Configuration example of dummy pattern]

FIG. 13 is a diagram for depicting an example of a cross-sectional view of the dummy pattern 224 in the embodiment of the present technique. The dummy pattern 224 includes dummy wirings 224-3 and 224-2. The dummy wiring 224-3 is wired to the rear surface-side wiring layer M3. The dummy wiring 224-2 is wired to the rear surface-side wiring layer M2 in the lower layer of the rear surface-side wiring layer M3. As exemplified in the drawing, these dummy wirings 224-2 and 224-3 are insulated from the local wiring 225 and are electrically floating.

It should be noted that the dummy wirings 224-3 and 224-2 are examples of the first and second dummy wirings described in Claims.

FIG. 14 depicts diagrams each depicting an example of a plan view of the dummy pattern 224 in the embodiment of the present technique. In the drawings, a is an example of a plan view of the rear surface-side wiring layer M3 in which the dummy wiring 224-3 is wired, and b in the drawings is an example of a plan view of the rear surface-side wiring layer M2 in which the dummy wiring 224-2 is wired. It should be noted that in the drawings, the pattern of the dummy wiring 224-3 and the pattern of the dummy wiring 224-2 are different from each other for convenience of description, but the materials of these wirings are the same.

As exemplified in a in the drawings, the dummy wiring 224-3 is wired in a mesh shape in the X-Y plane. In addition, as exemplified in b in the drawings, the dummy wiring 224-2 is also wired in a mesh shape in the X-Y plane. Further, the position of the dummy wiring 224-3 of the upper layer and the position of the dummy wiring 224-2 of the lower layer on the X-Y plane are different from each other.

For example, the dummy wiring 224-3 is not wired at a position X3, but the dummy wiring 224-2 is wired along the Y-axis direction. In addition, the dummy wiring 224-3 is wired along the Y-axis direction at a position X4, but the dummy wiring 224-2 is not wired.

In addition, the dummy wiring 224-3 is not wired at a position Y1, but the dummy wiring 224-2 is wired along the X-axis direction. In addition, the dummy wiring 224-3 is wired along the X-axis direction at a position Y2, but the dummy wiring 224-2 is not wired.

It should be noted that although the structure of FIG. 1 is applied to the solid-state imaging apparatus 100, it can be applied to a semiconductor apparatus other than the solid-state imaging apparatus 100 if the rewiring is taken out from the rear surface. As an advantage of the configuration in which the rewiring is taken out from the rear surface, for example, silicon of a chip can be brought into contact with a mounting substrate provided with a heat radiation plate to improve the heat radiation efficiency.

The improvement of heat radiation efficiency will be described. In general, in both a ceramic package and a WLCSP, the terminals are generally taken out from the upper surface side where a wiring layer exists. However, when the WLCSP is mounted, it becomes difficult to radiate heat if the surface where a device that is the main heat generator is formed faces upward. This is because the heat radiation mechanism is only thermal radiation and convection. In order to solve this problem, a method in which a heat radiation plate is directly attached to a mounting substrate and heat is radiated by heat conduction is considered. The details of this method are described in, for example, https://www.renesas.com/jp/ja/support/technical-resources/packaging/characteristic/heat-dissipation.

If a terminal is provided on the side of a wiring layer between the wiring layer and an insulating layer, the heat radiation efficiency becomes insufficient because the terminal comes into contact with a mounting substrate via the insulating layer from a silicon substrate that is the main heat generator. This is because the thermal conductivity of the insulating layer is generally lower than that of silicon. For example, the thermal conductivity of silicon is 160 watts per meter per Kelvin (W/m·K), and the thermal conductivity of the insulating layer of silicon dioxide is 1.3 watts per meter per Kelvin (W/m·K).

Therefore, in the case where the heat radiation efficiency is to be improved, a structure in which the terminals are taken out from the rear surface of the silicon substrate as depicted in FIG. 1 is preferable such that the silicon substrate can be directly attached to the mounting substrate. In addition, even in a semiconductor apparatus other than the solid-state imaging apparatus 100, the effect obtained by conforming to the KOZ rule and the effect of the suppression of an increase in capacity when the wafer is shared in the manufacturing process of the ceramic package can be similarly obtained by the structure of FIG. 1.

As described above, according to the embodiment of the present technique, since the dummy pattern 224 is formed around the dummy non-forming region 230 penetrating up to the front surface-side wiring layer M5 from the rear surface of the laminated wafer 201, the parasitic capacitance between the rear surface and the front surface-side wiring layers M4 and M5 can be reduced. Accordingly, characteristics such as operation speeds can be improved.

### [First modified example]

In the above-described embodiment, the shape of the boundary region between the opening 223 for a TSV and the local wiring 225 is a ring shape, but is not limited to this shape. A laminated wafer 200 of a first modified example of the embodiment differs from the embodiment in that the shape of the boundary region is a circular shape.

FIG. 15 depicts diagrams for depicting an example of a cross-sectional view and a plan view of an opening for a TSV in the first modified example of the embodiment of the present technique. In the drawings, a is an example of a cross-sectional view of an opening 223 for a TSV, and b in the drawings is an example of a plan view of the opening 223 for a TSV when viewed from the lower side of a logic substrate 220.

As exemplified in b in the drawings, in the first modified example of the embodiment, the shape of the boundary region between the opening 223 for a TSV and a local wiring 225 is a circular shape. By making the boundary region circular, which is simpler than a ring, it is easier to form a TSV and a rewiring than in the case of a ring shape. It should be noted that the shape of the boundary region is not limited to a circle or a ring, and may be a polygon or the like.

As described above, according to the first modified example of the embodiment, since the shape of the boundary region is a circular shape, it is easy to form the TSV and the rewiring.

### [Second modified example]

In the above-described embodiment, the dummy pattern 224 is made in an electrically floating state, but is not limited to this configuration. A laminated wafer 200 of a second modified example in the embodiment differs from the embodiment in that a part of a dummy pattern 224 and a wiring layer of a local wiring 225 are short-circuited.

FIG. 16 is a diagram for depicting an example of a cross-sectional view of a dummy pattern in the second modified example of the embodiment of the present technique. As exemplified in the drawing, a part of the dummy pattern 224 and a front surface-side wiring layer M4 of the local wiring 225 are short-circuited. In addition, the side surface of an opening 223 for a TSV is formed stepwise. According to the configuration of the drawing, the metal forming the TSV is brought into contact with the metal of the local wiring 225 on the side surface of the opening 223 for a TSV, so that the contact resistance of the TSV can be reduced. Therefore, the diameter of the TSV can be made smaller.

As described above, according to the second modified example of the embodiment of the present technique, since a part of the dummy pattern 224 and the front surface-side wiring layer M4 are short-circuited, the contact resistance of the TSV can be reduced.

### [Third modified example]

In the above-described embodiment, the dummy wirings 224-3 and 224-2 are wired in a mesh shape, but the dummy pattern 224 is not limited to the wiring in a mesh shape. A laminated wafer 200 of a third modified example in the embodiment differs from the embodiment in that a dummy pattern 224 includes a plurality of islands.

FIG. 17 is a diagram for depicting an example of a cross-sectional view of the dummy pattern 224 in the third modified example of the embodiment of the present technique. The dummy pattern 224 includes islands 224-6, 224-5, and 224-4. The islands 224-6, 224-5, and 224-4 are island-like conductors. The islands 224-6 are arranged in a rear surface-side wiring layer M3. The islands 224-5 are arranged in a rear surface-side wiring layer M2 in the lower layer of the rear surface-side wiring layer M3. The islands 224-4 are arranged in a rear surface-side wiring layer M1 in the lower layer of the rear surface-side wiring layer M2.

FIG. 18 depicts diagrams each depicting an example of a plan view of the dummy pattern 224 in the embodiment of the present technique. In the drawings, a is an example of a plan view of the rear surface-side wiring layer M3 in which the islands 224-6 are arranged, and b in the drawings is an example of a plan view of the rear surface-side wiring layer M2 in which the islands 224-5 are arranged. In the drawings, c is an example of a plan view of the rear surface-side wiring layer M1 in which the islands 224-4 are arranged. It should be noted that in the drawings, the patterns of the islands 224-6 to 224-4 are different from each other for convenience of description, but the materials are the same.

As exemplified in a in the drawings, a plurality of islands 224-6 are arranged in a two-dimensional lattice shape in the rear surface-side wiring layer M3. As exemplified in b in the drawings, a plurality of islands 224-5 are arranged in a two-dimensional lattice shape even in the rear surface-side wiring layer M2. As exemplified in c in the drawings, a plurality of islands 224-4 are arranged in a two-dimensional lattice shape even in the rear surface-side wiring layer M1. The shape of each island is, for example, a rectangular shape.

In addition, the positions of the islands 224-6 on the X-Y plane are different from the positions of the islands 224-5 in the lower layer. In addition, the positions of the islands 224-5 on the X-Y plane are different from the positions of the islands 224-4 in the lower layer.

For example, the islands 224-6 and 224-4 are not arranged at a position X3, but the islands 224-5 are arranged along the Y-axis direction. The islands 224-6 and 224-4 are arranged along the Y-axis direction at a position X4, but the islands 224-5 are not arranged.

In addition, the islands 224-6 are not arranged at a position Y1, but the islands 224-5 and 224-4 are arranged along the X-axis direction. In addition, the islands 224-6 are arranged along the X-axis direction at a position Y2, but the islands 224-5 and 224-4 are not arranged.

As exemplified in the drawings, by configuring the dummy pattern 224 to be a pattern including a plurality of islands, the parasitic capacitance can be reduced more than in the case of a mesh shape.

It should be noted that as exemplified in FIG. 19, the side surface of the opening 223 for a TSV may be formed stepwise rather than a tapered shape.

It should be noted that a part of the dummy pattern 224 and the local wiring 225 may be short-circuited via contacts. At this time, in the dummy pattern 224, only an inner peripheral region within a certain distance from the outer periphery of the opening 223 for a TSV may be short-circuited. By making only the inner peripheral region short-circuited, the effect of the parasitic capacitance can be reduced.

As described above, according to the third modified example of the embodiment of the present technique, since the dummy pattern 224 includes a plurality of islands, the parasitic capacitance can be further reduced.

### <2. Example of application to mobile body>

The technique (the present technique) according to the present disclosure can be applied to various products. For example, the technique according to the present disclosure may be realized as an apparatus mounted on any type of mobile body such as an automobile, an electric automobile, a hybrid electric automobile, a motorcycle, a bicycle, a personal mobility, an airplane, a drone, a ship, or a robot.

FIG. 20 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 20, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 20, an audio speaker 12061, a display section 12062, and an instrument panel 12063 are illustrated as the output device. The display section 12062 may, for example, include at least one of an on-board display and a head-up display.

FIG. 21 is a diagram depicting an example of the installation position of the imaging section 12031.

In FIG. 21, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 21 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technique according to the present disclosure can be applied has been described above. The technique according to the present disclosure can be applied to, for example, the imaging section 12031 among the configurations described above. Specifically, for example, the solid-state imaging apparatus 100 of FIG. 3 can be applied to the imaging section 12031. By applying the technique according to the present disclosure to the imaging section 12031, it is possible to reduce the parasitic capacitance and improve the characteristics such as operation speeds. It should be noted that in addition to the on-vehicle use described above, the technique according to the present disclosure can be applied to a general-purpose camera (surveillance, medical, industrial, digital, mobile, or the like), an analog front end, RF (Radio Frequency), power management, and the like other than on-vehicle.

It should be noted that the above-described embodiment depicts an example for embodying the present technique, and the matters in the embodiment and the invention specifying matters in Claims have correspondence relations. Similarly, the invention specifying matters in Claims and the matters in the embodiment of the present technique having the same names have correspondence relations. However, the present technique is not limited to the embodiment, and can be further embodied by applying various variations to the embodiment in the range without deviating from the gist thereof.

It should be noted that the effects described in the description are only illustrative and are not limitative, and there may be other effects.

Note that the present technology may also be implemented in the following configurations.
(1) A semiconductor apparatus including:
   an opening for a pad that is formed on a front surface of a substrate and provided with a predetermined electrode pad;
   a wiring layer that is formed in the substrate; and
   a dummy pattern that is formed around a dummy non-forming region penetrating up to the wiring layer from a rear surface relative to the front surface.
(2) The semiconductor apparatus according to (1) above, in which
   the substrate is a substrate obtained by laminating a pixel sensor substrate and a logic substrate,
   the opening for a pad is formed on the front surface of the pixel sensor substrate, and
   the wiring layer and the dummy pattern are formed in the logic substrate.
(3) The semiconductor apparatus according to (1) or (2) above, in which
   the dummy non-forming region is opened, and a TSV (Through Silicon Via) is formed.
(4) The semiconductor apparatus according to any one of (1) to (3) above, in which
   an area of the dummy non-forming region on a plane parallel to the substrate is smaller as it becomes closer to the wiring layer.
(5) The semiconductor apparatus according to any one of (1) to (4) above, in which
   a position of the opening for a pad on a plane parallel to the substrate and a position of the dummy non-forming region on the plane are different from each other.
(6)
   The semiconductor apparatus according to any one of (1) to (5) above, in which
   a shape of a boundary region between the wiring layer and the dummy non-forming region is a circular shape.
(7) The semiconductor apparatus according to any one of (1) to (5) above, in which
   a shape of the boundary region between the wiring layer and the dummy non-forming region is a ring shape.
(8) The semiconductor apparatus according to any one of (1) to (5) above, in which
   the dummy non-forming region is in contact with the wiring layer in a plurality of boundary regions.
(9) The semiconductor apparatus according to any one of (1) to (8) above, in which
   a part of the dummy pattern and the wiring layer are short-circuited.
(10) The semiconductor apparatus according to any one of (1) to (9) above, in which
   a density of the dummy pattern is higher as it becomes closer to the wiring layer.
(11) The semiconductor apparatus according to any one of (1) to (10) above, in which
   the dummy pattern includes dummy wiring wired in a mesh shape.
(12) The semiconductor apparatus according to (11) above, in which
   the dummy wiring includes a first dummy wiring and a second dummy wiring wired between the first dummy wiring and the wiring layer, and
   a position of the second dummy wiring on a plane parallel to the substrate is different from that of the first dummy wiring.
(13) The semiconductor apparatus according to any one of (1) to (10) above, in which
   the dummy pattern includes a plurality of islands arranged in a two-dimensional lattice shape.
(14) The semiconductor apparatus according to (13) above, in which
   the plurality of islands include a first island and a second island wired between the first island and the wiring layer, and
   a position of the second island on a plane parallel to the substrate is different from that of the first island.
(15) The semiconductor apparatus according to any one of (1) to (14) above, in which
   a side surface of the dummy non-forming region is formed in a tapered shape.
(16) The semiconductor apparatus according to any one of (1) to (14) above, in which
   a side surface of the dummy non-forming region is formed stepwise.

### [Reference Signs List]

- 100:: Solid-state imaging apparatus
- 110:: Vertical driving circuit
- 120:: Control circuit
- 130:: Pixel region
- 140:: Column signal processing circuit
- 150:: Horizontal driving circuit
- 160:: Output circuit
- 170:: Logic circuit
- 200, 201:: Laminated wafer
- 210:: Pixel sensor substrate
- 211, 221:: Si (semiconductor) substrate
- 212, 222:: Interlayer film
- 213:: Opening for pad
- 214, 227:: Wiring for external connection
- 215, 228:: Connection part
- 216:: Pixel
- 217:: Electrode pad
- 220:: Logic substrate
- 223:: Opening for TSV
- 224:: Dummy pattern
- 224-1 to 224-3:: Dummy wiring
- 224-4 to 224-6:: Island
- 225, 229:: Local wiring
- 226:: Global wiring
- 230:: Dummy non-forming region
- 310:: WLCSP
- 311:: TSV
- 312, 324:: Rewiring
- 313, 325:: External terminal
- 320:: Ceramic package
- 321:: Glass
- 322:: Ceramic substrate
- 323:: Wire
- 12031:: Imaging section

## Claims

1. A semiconductor apparatus comprising:
an opening for a pad that is formed on a front surface of a substrate and provided with a predetermined electrode pad;
a front surface-side wiring layer that is formed in the substrate; and
a dummy pattern that is formed around a dummy non-forming region penetrating up to the front surface-side wiring layer from a rear surface relative to the front surface.

2. The semiconductor apparatus according to claim 1, wherein
the substrate is a substrate obtained by laminating a pixel sensor substrate and a logic substrate,
the opening for a pad is formed on the front surface of the pixel sensor substrate, and
the front surface-side wiring layer and the dummy pattern are formed in the logic substrate.

3. The semiconductor apparatus according to claim 1, wherein
the dummy non-forming region is opened, and a TSV (Through Silicon Via) is formed.

4. The semiconductor apparatus according to claim 1,
wherein an area of the dummy non-forming region on a plane parallel to the substrate is smaller as it becomes closer to the front surface-side wiring layer.

5. The semiconductor apparatus according to claim 1, wherein
a position of the opening for a pad on a plane parallel to the substrate and a position of the dummy non-forming region on the plane are different from each other.

6. The semiconductor apparatus according to claim 1, wherein
a shape of a boundary region between the front surface-side wiring layer and the dummy non-forming region is a circular shape.

7. The semiconductor apparatus according to claim 1, wherein
a shape of the boundary region between the front surface-side wiring layer and the dummy non-forming region is a ring shape.

8. The semiconductor apparatus according to claim 1, wherein
the dummy non-forming region is in contact with the front surface-side wiring layer in a plurality of boundary regions.

9. The semiconductor apparatus according to claim 1, wherein
a part of the dummy pattern and the front surface-side wiring layer are short-circuited.

10. The semiconductor apparatus according to claim 1, wherein
a density of the dummy pattern is higher as it becomes closer to the front surface-side wiring layer.

11. The semiconductor apparatus according to claim 1, wherein
the dummy pattern includes dummy wiring wired in a mesh shape.

12. The semiconductor apparatus according to claim 11, wherein
the dummy wiring includes a first dummy wiring and a second dummy wiring wired between the first dummy wiring and the front surface-side wiring layer, and
a position of the second dummy wiring on a plane parallel to the substrate is different from that of the first dummy wiring.

13. The semiconductor apparatus according to claim 1, wherein
the dummy pattern includes a plurality of islands arranged in a two-dimensional lattice shape.

14. The semiconductor apparatus according to claim 13, wherein
the plurality of islands include a first island and a second island wired between the first island and the front surface-side wiring layer, and
a position of the second island on a plane parallel to the substrate is different from that of the first island.

15. The semiconductor apparatus according to claim 1, wherein
a side surface of the dummy non-forming region is formed in a tapered shape.

16. The semiconductor apparatus according to claim 1, wherein
a side surface of the dummy non-forming region is formed stepwise.
